# EUROPEAN PATENT APPLICATION

(11) **EP 1 452 881 A1**
(43) Date of publication of application: **01.09.2004**
(21) Application number: 04250972.9
(22) Date of filing: 23.02.2004
(51) Int. Cl.: G01R 31/28

(54) **Printed circuit board and method of use thereof**

(30) Priority: 27.02.2003 GB 0304440
(71) Applicant: Pace Micro Technology Ltd, Saltaire, Shipley BD18 3LF (GB)
(72) Inventor: Fielding, Vic, Shipley, BD18 3LF (GB)
(74) Representative: Tomkinson, Alex

(57) **Abstract**

A printed circuit board (PCB) (2) is provided for use with electrical apparatus. The PCB has a body with a surface provided for the location of electrical components (8) thereon and electrically conductive tracks (6) are provided for electrically connecting the component in a required arrangement. A portion of the PCB body has a test port (12) thereon for allowing testing of functions of the PCB, electrical conductive tracks and/or electrical components. The testing portion (10) of the PCB body provided with the test ports (12) is detachably attached to the PCB body to allow removal therefrom.

## Description

This invention relates to a printed circuit board (PCB), and particularly to a PCB including one or more testing ports on a portion or surface of the body of the PCB.

PCBs are conventionally used in items of electrical apparatus for the assembly and connection of a plurality of electrical components together. The PCBs can be multi-layered or single layered and generally include at least one surface on which a plurality of electrically conductive tracks are provided for the connection of electrical components.

It is generally the case that one or more functions of the PCB are tested prior to the PCB being assembled in apparatus or being shipped to a customer. One or more test ports are typically provided on one or more surfaces of the PCB to allow the connection of testing equipment thereto. However, the provision of these test ports also allows third parties to subsequently analyse the PCB and/or the electrical components thereon, thereby allowing them to gain unauthorised information relating to the control logic and/or control system associated therewith.

It is therefore an aim of the present invention to provide a PCB which allows secure testing to be carried out thereon and which overcomes the abovementioned problem.

According to a first aspect of the present invention there is provided a printed circuit board (PCB) for use with electrical apparatus, said PCB having a body with at least one surface provided for the location of one or more electrical components thereon and one or more electrically conductive tracks for electrically connecting said one or more electrical components in a required arrangement, at least a portion of the PCB body having one or more test ports thereon for allowing testing of one or more functions of said PCB, electrical conductive tracks and/or electrical components, and wherein the portion of the PCB body provided with said one or more test ports is detachably attached to said PCB body to allow removal therefrom.

The advantage of the present invention is that by allowing removal of the portion of the PCB having the one or more test ports thereon (hereinafter referred to as the testing port portion) from the main body of the PCB, this prevents or at least reduces the likelihood of third parties being able to gain unauthorised access to the control systems of the PCB or electrical apparatus in which the PCB is mounted.

The at least one testing portion is typically removed from the main body of the PCB after testing of the PCB or electrical apparatus has taken place.

Preferably the at least one testing portion can be detachably attached to the main body of the PCB by attachment means including any or any combination of one or more frangible portions, clips, perforations, slots and/or the like. The testing portion is therefore typically snapped or pulled off when removal of the portion from the body of the PCB is required.

The at least one testing portion can be provided as a protruding part or parts of the main body of the PCB. Alternatively, the at least one testing portion can be provided on a peripheral edge of the PCB body or can be provided at a location within the peripheral edges of the PCB body, thereby leaving at least one recess or aperture respectively in the main body of the PCB after removal of the testing portion(s) therefrom.

In one embodiment the body of the PCB is located in or with a housing in use and the housing is provided with means for obstructing the location of the PCB therein if the one or more testing port portions have not first been removed from the body of the PCB.

The obstruction means can include one or more protruding members, such as flanges, posts and/or the like which are provided in the housing at one or more pre-determined locations and which prevent the body of the PCB from being seated in a required position in the housing unless the at least one testing port portion is first removed.

The PCB can be single sided or double sided and preferably the PCB is a multi-layered board (i.e., two or more surfaces having a number of electrical components and/or electrically conductive tracks associated therewith) since if the electrically conductive tracks communicating with the one or more test ports are provided on an inner layer, it will be difficult, if not impossible, for a third party to gain access to the tracks. The tracks of single layered or double sided boards may be accessed more easily by an unauthorised third party.

According to a second aspect of the present invention there is provided a method of using a printed circuit board (PCB), said PCB having a body with at least one surface for the provision of one or more electrical components thereon and one or more electrically conductive tracks for electrically connecting said one or more electrical components and wherein said method includes the step of testing one or more functions of the PCB, electrical conductive tracks and/or electrical components using one or more test ports provided on at least a portion of the PCB body and, on completion of said testing, removing the portion(s) of the PCB body provided with said one or more testing ports thereon.

According to a further aspect of the present invention there is provided a PCB and housing assembly, the housing assembly being provided with means for obstructing location of the PCB in the housing assembly unless at least a portion of the PCB having one or more test ports provided thereon has first been removed.

According to a yet further aspect of the present invention there is provided a housing assembly for use with a PCB, the housing assembly provided with obstruction means for obstructing location of the PCB in the housing unless at least a portion of the PCB having one or more test ports provided thereon has first been removed.

Thus the present invention provides a novel way of providing a connector for a PCB for development and production testing during manufacture and which can be easily removed to prevent unauthorised modification to the control system provided, at least in part, by the PCB.

Embodiments of the present invention will now be described with reference to the following figures, wherein:
Figure 1 is a detailed plan view of a PCB according to an embodiment of the present invention;
Figures 2a-2c are simplified plan views of PCBs according to further embodiments of the present invention; and
Figure 3a-3c illustrate the PCB in figure 2a being located in a housing according to an embodiment of the present invention.

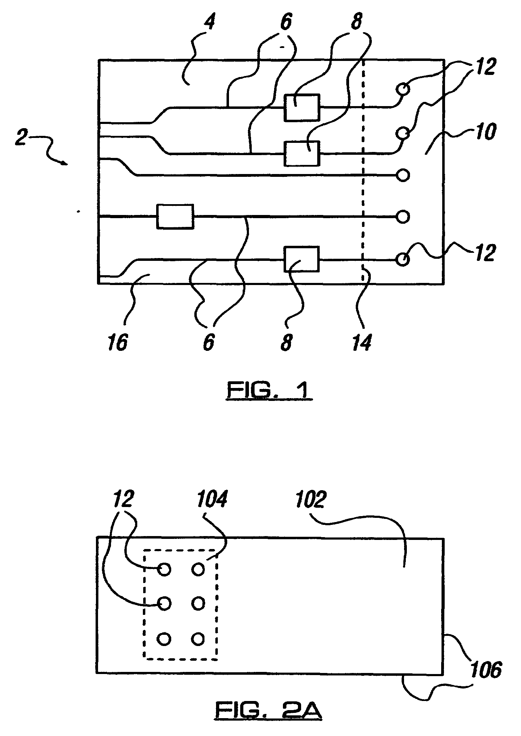

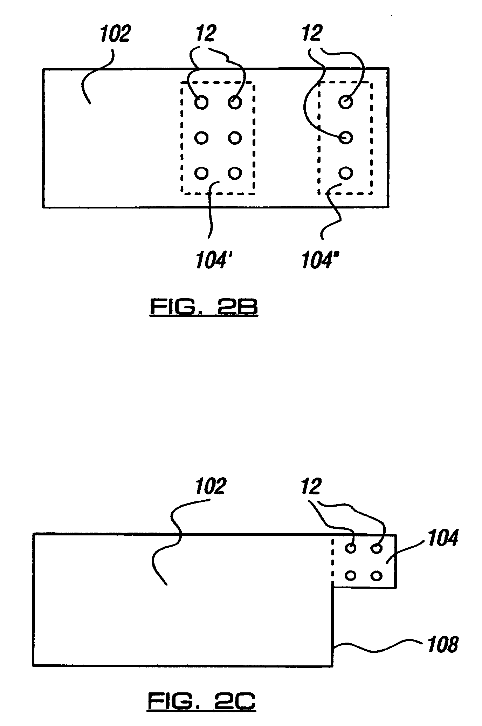

Referring firstly to figure 1, there is illustrated an example of a printed circuit board (PCB) 2 according to an embodiment of the present invention. An upper surface 4 of the PCB is provided with a number of electrical conductive tracks 6 thereon arranged in a pre-determined configuration and which connect with one or more electrical components 8. The electrical components can be soldered onto the surface of the PCB during assembly or one or more aperture can be provided in the PCB surface 4 via which the components can be attached to the PCB.

An end portion 10 of the PCB is provided with a number of test ports 12 thereon. These test ports are used to test one or more functions of the PCB 2, the electrical components 8 or the electrical tracks 6.

In accordance with the present invention, the end portion 10 is connected to the main body portion 16 of the PCB via a frangible portion 14, thereby allowing end portion 10 to be snapped off from the remaining portion 16 of the PCB once one or more of the test ports have been used to test the PCB. Once the test ports are removed, this prevents third parties from gaining access to the control systems of the PCB. As such, end portion 10 provides a removable connector for allowing testing of the PCB whilst meeting the requirements set by encryption organisations and/or similar bodies.

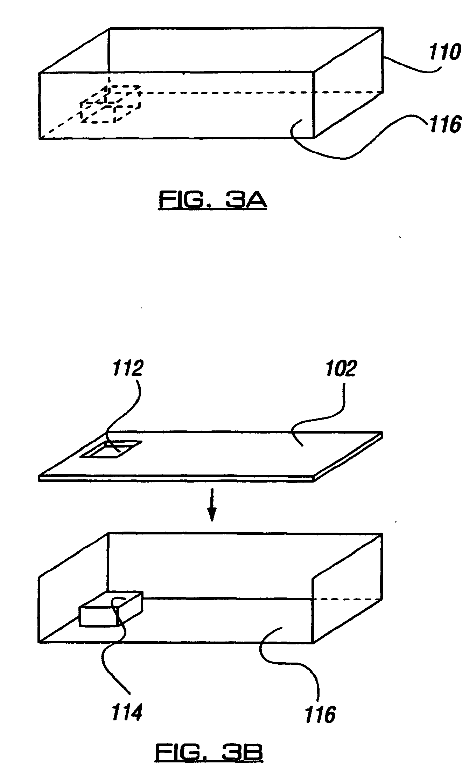

In addition to providing the removable portion of the PCB adjacent an end thereof as shown in figure 1, the removable portion 104 of the PCB can be provided at any required position on the body 102 of the PCB, such as within the peripheral edges 106 of the PCB, as shown in figure 2a, or protruding from a peripheral edge 108 of the PCB, as shown in figure 2c. In addition, two or more removable portions 104', 104" having testing ports thereon can be provided in the PCB.

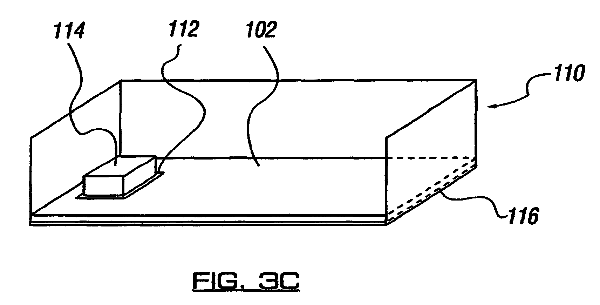

When assembled in use, the PCB 102 can be provided in a housing 110 as shown in figures 3a-3c. The front wall of the housing has been omitted in figures 3b and 3c for the purposes of clarity. The PCB is of the type shown in figure 2a and the removable portion 104 has been removed to leave an aperture 112 in the body of the PCB.

In order to ensure that the removable portion is removed following testing of the PCB and prior to shipping the PCB or electrical apparatus in which the PCB is provided to a customer, obstruction means in the form of an upwardly protruding arm 114 is provided on base 116 of housing 110.

The PCB cannot be seated on base 116 of housing 110 until portion 104 has been removed from the PCB to leave aperture 112. Once portion 104 is removed, aperture 112 is located over arm 114 to allow correct seating of the PCB in the base 116 of housing 110.

The electrical connection tracks to the removable portion of the PCB can be provided using buried layers, thereby preventing easy access to the tracks.

The PCBs can be multi-layered or single layered boards and be provided in any required size, shape and have any number of required tracks and/or components thereon.

Thus the removable portions or test port connectors provide easy access to the control logic of a PCB but allows this access to be removed once testing of the PCB has been completed.

## Claims

1. A printed circuit board (PCB) for use with electrical apparatus, said PCB having a body with at least one surface provided for the location of one or more electrical components thereon and one or more electrically conductive tracks for electrically connecting said one or more electrical component in a required arrangement, at least a portion of the PCB body having one or more test ports thereon for allowing testing of one or more functions of said PCB, electrical conductive tracks and/or electrical components, and wherein the portion of the PCB body provided with said one or more test ports is detachably attached to said PCB body to allow removal therefrom.

2. A PCB according to claim 1 wherein the at least one testing portion is removed from the main body of the PCB after testing of the PCB or electrical apparatus has taken place.

3. A PCB according to claim 1 wherein the at least one testing portion is detachably attached to the main body of the PCB by attachment means including any or any combination of one or more frangible portions, clips, perforations or slots.

4. A PCB according to claim 1 wherein the at least one testing portion is provided as a protruding part of the main body of the PCB.

5. A PCB according to claim 1 wherein the at least one testing portion is provided on a peripheral edge of the PCB body.

6. A PCB according to claim 1 wherein the at least one testing portion is provided within the peripheral edges of the PCB body and detachment of the at least one testing portion from the PCB body results in one or more apertures being provided in the PCB body.

7. A PCB according to claim 1 wherein the PCB body is located in or with a housing in use, the housing being provided with means for obstructing the location of the PCB therein if the one or more testing portions has not been removed from the body of the PCB.

8. A PCB according to claim 7 wherein the obstruction means in the housing includes one or more protruding members.

9. A PCB according to claim 1 wherein the PCB is a multi-layered board and the electrically conductive tracks are provided on an inner layer thereof.

10. A method of using a printed circuit board (PCB), said PCB having a body with at least one surface for the provision of one or more electrical components thereon and one or more electrically conductive tracks for electrically connecting said one or more electrical components and wherein the method includes the steps of testing one or more functions of the PCB, electrical conductive tracks and/or electrical components using one or more testing ports provided on at least a portion of the PCB body and, on completion of said testing, removing the portion(s) of the PCB body provided with said one or more testing ports thereon.

11. A PCB and housing assembly, the housing assembly being provided with means for obstructing location of the PCB in the housing unless at least a portion of the PCB having one or more test ports provided thereon has first been removed.

12. A housing assembly for use with a PCB, the housing assembly provided with obstruction means for obstructing location of the PCB in the housing unless at least a portion of the PCB having one or more test ports provided thereon has first been removed.
